# EUROPEAN PATENT SPECIFICATION

(11) **EP 2 854 485 B1**
(45) Date of publication and mention of the grant of the patent: **12.06.2019**
(21) Application number: 14182057.1
(22) Date of filing: 25.08.2014
(51) Int. Cl.: H05B 33/08

(54) **PWM dimming**
PWM-Dimmen
Gradation PWM

(30) Priority: 30.08.2013 FI 20135877
(43) Date of publication of application: 01.04.2015
(73) Proprietor: Helvar Oy Ab, 02150 Espoo (FI)
(72) Inventor: Marttila, Markus, 20760 Piispanristi (FI)
(74) Representative: Berggren Oy, Helsinki & Oulu

(56) References cited:
- EP-A1- 2 418 918
- EP-A2- 1 986 470
- WO-A1-2008/007121
- WO-A1-2009/156891
- JP-A- 2012 094 457
- US-A1- 2010 225 247
- US-A1- 2011 084 734
- US-A1- 2012 274 877

## Description

### FIELD OF THE INVENTION

The invention relates to control of operation of a driver arranged to drive one or more light emitting diode (LED) light sources. In particular, embodiments of the invention relate to a driver apparatus and a use of a driver apparatus for providing light intensity control of LED light sources.

### BACKGROUND

A LED driver typically provides a possibility for controlling the characteristics of the output current provided from the LED driver in order to enable control of light intensity of a LED light source driven by the LED driver. Typically, the instantaneous level and/or the average level of the output current can be adjusted by issuing an appropriate control signal to the LED driver. Consequently, the light intensity of the LED light source is changed in accordance with the level of the output current. The light intensity control may also be referred to as dimming.

One technique to implement LED dimming is to directly adjust the output current to the desired level within a predetermined range of output currents, typically ranging from a non-zero minimum output current *I*ₘᵢₙ to the maximum output current *I*ₘₐₓ. Such dimming technique may be based on an analog control signal whose level (e.g. voltage) directly indicates the desired level of the output current. This dimming technique is herein referred to as intensity dimming, intensity control or analog dimming. While the intensity control provides straightforward and accurate control of light intensity, drawbacks of this dimming technique include the inability to provide low(est) light intensity levels. Moreover, this dimming technique requires that the LED driver is able to provide the output current at selectable or adjustable level and hence it may not be suitable for all LED drivers, e.g. for LED drivers that are able provide the output current at a fixed predetermined level.

Another technique to implement LED dimming is to switch the output current between the maximum output current *I*ₘₐₓ and zero current in order to provide the desired average output current. When switched at a high enough frequency (e.g. around 500 to 1000 Hz), the periods of zero current, causing the light being momentarily switched off, are short enough to be unperceivable by a human observer but are rather perceived as reduced light intensity. Such dimming technique may be based on a digital control signal, e.g. a Pulse Width Modulation (PWM) signal exhibiting the desired duty cycle *D*_{ctrl} at a suitable cycle frequency *f*_{ctrl}. Consequently, the envelope of the output current may be arranged to follow or approximate the PWM signal and the resulting average output current follows or approximates the duty cycle such that the average output current approximates *I*_{avg} = *D*_{ctrl} x *I*ₘₐₓ. Such dimming technique is herein referred to as PWM dimming or PWM control.

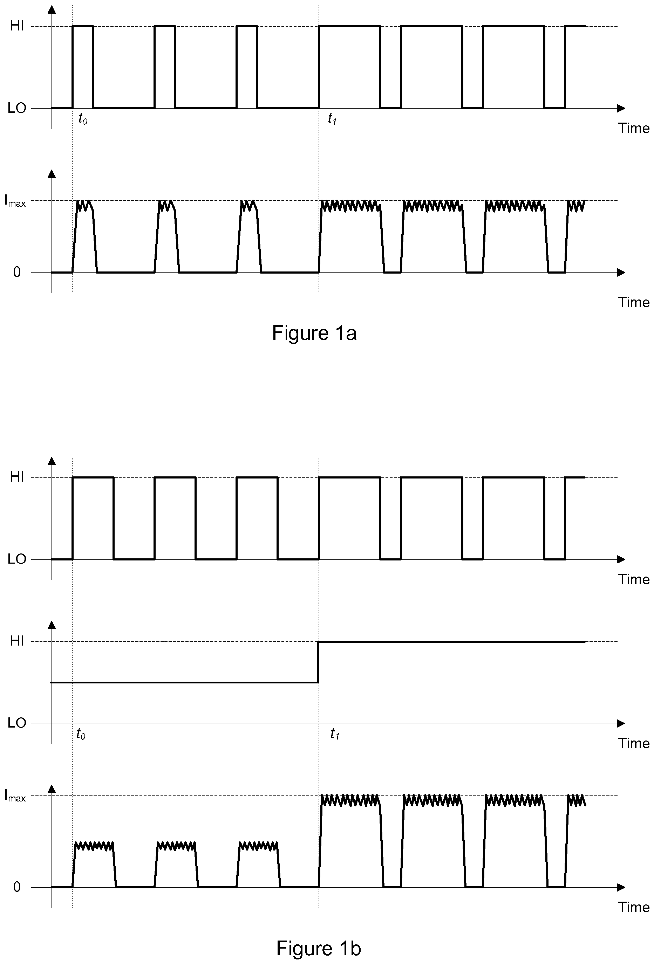

Figure 1a illustrates the concept of PWM dimming. The upper curve in Figure 1a depicts a PWM control signal. In this example, from time *t₀* until time *t₁* the PWM control signal applies duty cycle of (approx.) 25 %, whereas from time *t₁* onwards the PWM control signal applies duty cycle of (approx.) 75 %. The lower curve of Figure 1a illustrates the corresponding output current. As can be seen in Figure 1a, the envelope of the output current follows the shape of the PWM control signal. The periods of the output current corresponding to the pulses of the PWM control signal (which may also be referred to as active periods of the PWM signal or periods of on-time of the PWM signal) exhibit a high-frequency ripple that results from the switching frequency of a switched-mode power supply typically applied in a power converter unit of a LED driver. It should be noted that while in Figure 1a the PWM control signal and the resulting output current are depicted as temporally aligned signals (i.e. the beginnings of the pulses in the output current are temporally aligned with the corresponding pulses of the PWM control signal), in a real-life scenario the operation of the LED driver typically causes processing delays that result in a (constant or essentially constant) time shift between the PWM control signal and the output current.

While the PWM dimming provides a straightforward technique for controlling the light intensity and also enables controlling light intensity levels provided using a LED driver that applies a fixed predetermined output current level, drawbacks of this technique include perceivable steps in change of light intensity (at least partially due to the switching operation of the switched-mode power converter applied in the LED driver). Another drawback is the flickering of light especially at low duty cycles when the pulse width is narrow such that (temporal) distances between the pulses are long enough to result in perceivable periods of the light being momentarily switched off.

To at least partially address the drawbacks of the PWM dimming and the intensity control, a hybrid dimming may be applied. The hybrid dimming is a technique that applies a combination of the PWM control and the intensity control. Typically, hybrid dimming applies both the PWM control and the intensity control at low light intensity levels while at the high light intensity levels only the PWM control with the maximum output current *I*ₘₐₓ (during pulses of the PWM signal) is applied. In particular, at the low light intensity levels the output current level is set to a lowered value (compared to the maximum output current *I*ₘₐₓ), thereby enabling usage of higher duty cycle.

Figure 1b illustrates the concept of hybrid dimming. The uppermost curve of Figure 1b depicts the PWM control signal, whereas the curve in the middle depicts the corresponding intensity controls signal. From time *t₀* until time *t₁* the PWM control signal exhibits duty cycle of (approx.) 50 %, while in the same time period the intensity control signal exhibits signal level that is approx. 50 % of the maximum level. From time *t₁* onwards the PWM control signal exhibits duty cycle of (approx.) 75 % while the intensity control signal exhibits the maximum level. The lowermost curve of Figure 1b depicts the resulting output current that has an envelope that follows the combined effect of the PWM control signal and the intensity control signal. When compared to the example of Figure 1a, now the output current within the period from time *t₀* to time *t₁* is approx. half of that of the example of Figure 1a. On the other hand, the durations of the non-zero current periods are approx. twice those of the corresponding periods of the example of Figure 1a. Consequently, the average output current of the example of Figure 1b is similar to that of the example of Figure 1a. From time *t₁* onwards, both the control signal and the resulting output current of the example of Figure 1b are similar to those of the example of Figure 1a.

The joint application of PWM control and intensity control techniques contributes to shortening the periods of zero current in the output of the LED driver that correspond to periods between the pulses of the PWM signal (in comparison to pure PWM control) at low light intensity levels. Consequently, the flickering of light at low light intensity levels can be reduced or even eliminated. However, a drawback of the hybrid dimming technique is the additional complexity of the LED driver for jointly operating the PWM control and the intensity control for reaching the desired average output current and hence the desired light intensity level.

In related art, WO 2008/007121 A1 discloses a driver apparatus for controlling a light source array comprising at least first and second light sources, the light source array used for illuminating a scan region on a target object, wherein light reflected from said target object is captured by a detector. The driver apparatus comprises a single integrated circuit comprising processing means for processing image data received from the detector, a switching array comprising at least first and second switches for switching the respective first and second light sources, and a current source for controlling the flow of current through the light sources. In this way the LED switching circuitry that controls an LED array is placed on the same integrated circuit (i.e. monolithic circuit) as the analogue processing circuitry that processes the image data, with the current source controlling the flow of current through the LEDs in the LED array. The current source has the advantage of avoiding rapid changes or slope discontinuities in the current flowing through the LEDs, which would otherwise cause unwanted transient signals. A shunt path comprising a switching device may be provided in parallel with the LED array and switching array. The shunt path has the advantage of enabling the switching sequence from one LED to another to be controlled such that a substantially constant current is drained from the supply (subject to any differences in the inherent current drawn by the Red, Green and Blue LEDs, respectively).

Further in related art, US 2012/274877 A1 discloses an LED driving circuit that drives a display backlight LED string including multiple LEDs connected in series. A power supply supplies a driving voltage from an output terminal thereof to a first end of the LED string. A detection resistor is arranged between a second end of the LED string and a fixed voltage terminal. The LED driving circuit receives a pulse modulation signal having a duty ratio that corresponds to the luminance. In the on period, in which the PDIM signal is the first level, the LED driving circuit controls the power supply such that the voltage drop across the detection resistor approaches a predetermined target value. In the off period, in which the PDIM signal is the second level, the LED driving circuit stops the control operation for the power supply.

Further in related art, WO 2009/156891 A1 discloses a switch mode power supply that energises a light emitting diode and that has a control circuit which subjects an energising pulse train to control modes in alternate sequence. When the magnitude of a half-wave rectified input voltage is less than a threshold voltage, the pulse train is subjected to a pulse width control mode during which the time duration of each pulse is constant. When the magnitude of the half-wave rectified input voltage is more than the threshold voltage, the pulse train is subjected to a peak current control mode in which the magnitude of a current pulse is limited. Combination of the two modes in the time domain enables an effective compromise to be reached between the conflicting requirements of high power factor and low current ripple.

Further in related art, US 2011/084734 A1 discloses a drive circuit and a method for maintaining an operating state of the drive circuit. The drive circuit includes a capacitor connected to an inverting input terminal of an operational amplifier and to a terminal of a current sensitive load through a switch. The output of the operational amplifier is connected to a switching regulator which has an output terminal connected to another terminal of the current sensitive load. An energy storage element is connected to the inverting input terminal of the operational amplifier. Energy is stored in the energy storage element during a first portion of a PWM pulse which is used during a second portion of the PWM pulse to generate the error signal. A drive signal is generated from the error signal where the drive signal is used to generate a voltage that biases the current source during the second portion of the PWM pulse.

### SUMMARY

Consequently, it is an object of the present invention to provide a dimming technique for LED light sources that enables straightforward control of light intensity level at a reasonable complexity, enables applying wide range of light intensity levels while at the same also contributes to avoiding perceivable flickering of light at low light intensity levels.

The objects of the invention are reached by a driver apparatus and by use of the driver apparatus or the arrangement as defined by the respective independent claims.

According to a first example embodiment, an apparatus for providing a driving current for one or more light emitting diodes is provided. The apparatus comprises a power converter portion comprising a switched-mode power converter entity for converting operating power supplied to the apparatus into the driving current in accordance with a driving signal, a driving portion for controlling provision of the driving current from the power converter portion in accordance with the voltage of a dimming control signal, the driving portion further arranged to alternately close and open a first switch of said switched-mode power converter entity at a switching frequency, and a pulse shaping portion for generating the dimming control signal on basis of a PWM signal that has a lower frequency than said switching frequency. The pulse shaping portion comprises a capacitor configured to receive a charging current and a second switch connected in parallel with the capacitor, the second switch arranged to control provision of the charge from the capacitor as the dimming control signal in accordance with the PWM signal. The apparatus further comprises a charging means coupled to the capacitor, the charging means configured to continuously charge the capacitor by a constant charging current, the pulse shaping portion thereby arranged to derive pulses of the dimming control signal on basis of the PWM signal such that rise time in the pulses of the dimming control signal is longer than that of the pulses of the PWM signal to provide an average driving current that is a smaller portion of a maximum current level than indicated by the duty cycle of the PWM signal.

According to a second example embodiment, a use of a pulse shaping portion to provide a dimming control signal for an apparatus for providing a driving current for one or more light emitting diodes is provided, the apparatus comprising a power converter portion comprising a switched-mode power converter entity for converting operating power supplied to the apparatus into the driving current in accordance with a driving signal and a driving portion for controlling provision of the driving current from the power converter portion in accordance with the voltage of the dimming control signal, the driver portion further arranged to alternately close and open a first switch of said switched-mode power converter entity at a switching frequency, during which use the pulse shaping portion generates the dimming control signal on basis of a PWM signal that has a lower frequency than said switching frequency, and during which use a capacitor comprised in the pulse shaping portion receives a charging current from a charging means coupled to the capacitor, which charging means is configured to continuously charge the capacitor by a constant charging current, and during which use a second switch connected in parallel with the capacitor controls provision of the charge from the capacitor as the dimming control signal in accordance with the PWM signal, and during which use the pulse shaping portion thereby derives pulses of the dimming control signal on basis of the PWM signal such that rise time in the pulses of the dimming control signal is longer than that of the pulses of the PWM signal to provide an average driving current that is a smaller portion of a maximum current level than indicated by the duty cycle of the PWM signal.

The exemplifying embodiments of the invention presented in this patent application are not to be interpreted to pose limitations to the applicability of the appended claims. The verb "to comprise" and its derivatives are used in this patent application as an open limitation that does not exclude the existence of also unrecited features. The features described hereinafter are mutually freely combinable unless explicitly stated otherwise.

The novel features which are considered as characteristic of the invention are set forth in particular in the appended claims. The invention itself, however, both as to its construction and its method of operation, together with additional objects and advantages thereof, will be best understood from the following detailed description of specific embodiments when read in connection with the accompanying drawings.

### BRIEF DESCRIPTION OF THE DRAWINGS

Some embodiments of the invention are illustrated by way of example, and not by way of limitation, in the figures of the accompanying drawings.
Figure 1a illustrates the concept of PWM dimming.
Figure 1b illustrates the concept of hybrid dimming.
Figure 2 schematically illustrates an arrangement comprising a LED driver in accordance with an embodiment of the invention.
Figure 3 schematically illustrates some components of a LED driver in accordance with an embodiment of the invention.
Figure 4 illustrates the dimming in accordance with an embodiment of the invention.
Figure 5 illustrates the dimming in accordance with an embodiment of the invention.
Figure 6a schematically illustrates a pulse shaping portion in accordance with an embodiment of the invention.
Figure 6b schematically illustrates a pulse shaping portion in accordance with an embodiment of the invention.
Figure 7a schematically illustrates a pulse shaping portion in accordance with an embodiment of the invention.
Figure 7b schematically illustrates a pulse shaping portion in accordance with an embodiment of the invention.
Figure 8 illustrates the dimming in accordance with an embodiment of the invention.

### DESCRIPTION OF SOME EMBODIMENTS

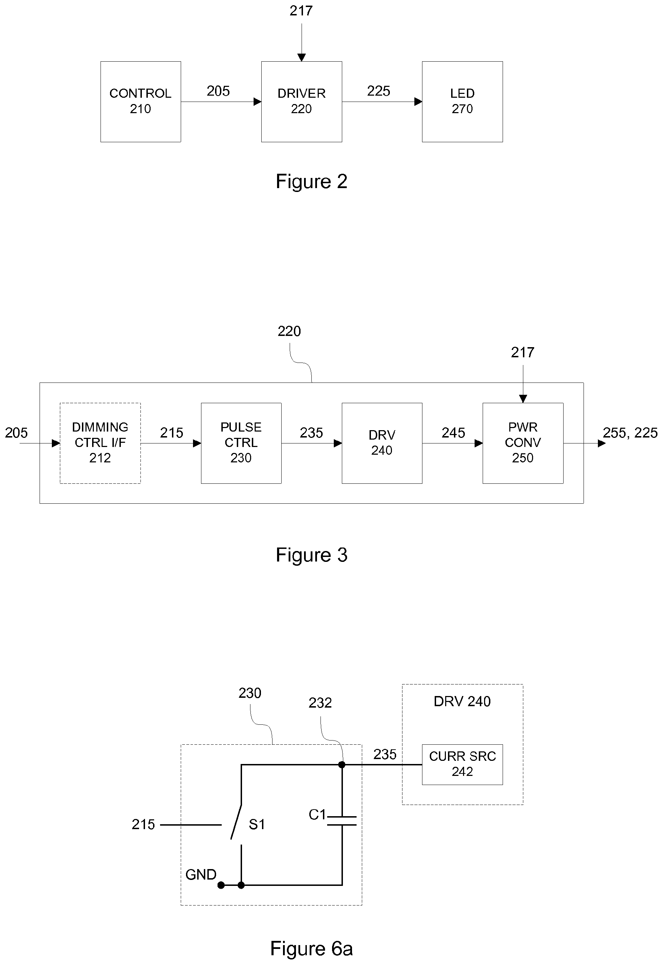

Figure 2 schematically illustrates an arrangement comprising a LED driver 220 for driving a LED light source 270. In the example arrangement depicted in Figure 2, the LED driver is coupled to a controller entity 210 for issuing input control signals 205 for controlling operation of the driver 220. The LED driver 220 is arranged to derive output current 225 on basis of operating power 217 provided thereto in accordance with the input control signal 205. The LED driver 220 is further coupled to the LED light source 270.

The controller entity 210 may be provided as a single controller entity providing the input control signals 205. Alternatively, although depicted as a single entity in Figure 2, the controller entity 210 may comprise a number of controller entities that are configured to operate jointly or independently of each other to provide the input control signals 205. The controller entity 210 may be arranged to issue the input control signals 205 in response to a user input via a user interface and/or in response to a further control signal received at the controller entity 210 from a further entity. The controller entity 210 may, alternatively or additionally, comprise a sensor, such as a PIR sensor or a light sensor, and it may be arranged to issue the control signals 205 in response to sensor measurements in accordance with a (respective) predetermined rule.

The input control signals 205 may be provided in a number of ways and/or in a number of formats. Typically, however, the input control signal 205 is provided as a command or request in accordance with a lighting control protocol. As an example in this regard, the input control signal 205 may be provided as a control signal providing one or more commands according to the Digital Addressable Lighting Interface (DALI) protocol specified in Appendix E.4 of the International Electrotechnical Commission (IEC) standard 60929, in other words as one or more DALI commands. A DALI command provided in an input control signal 205 may e.g. specify a desired or requested light intensity level associated with the output current 225, thereby implying a request for a certain average output current 225.

As a further example, the input control signal 205 may be provided as a control signal comprising one or more commands according to the 1-10 V lighting control signaling, as described/specified in Appendix E.2 of the International Electrotechnical Commission (IEC) standard 60929. In such a signal the voltage of the input control signal 205 may serve as an indication or as a request of the desired light intensity level associated with the output current 225, thereby implying a request for a certain average output current 225.

Although illustrated as a single entity, the LED light source 270 may comprise a single array of LEDs or, alternatively, two or more arrays of LEDs arranged in parallel. An array of LEDs may be referred to as a LED array. A LED array comprises either a single LED or two or more LEDs connected in series

Figure 3 schematically illustrates some components of a LED driver 220 for providing the output current 225 for the LED light source 270. The LED driver 220 comprises a pulse shaping portion 230 for generating a dimming control signal 235 on basis of a PWM control signal 215. The LED driver 220 further comprises a driving portion 240 for controlling provision of driving current 255 from a power converter portion 250. The LED driver 220 further comprises the power converter portion 250 for converting the operating power 217 supplied thereto into the driving current 255 in accordance with a driving signal 245 issued by the driving portion 240. The driving current 255 may be provided as the output current 225 or the driving current 255 may be used as basis for providing the output current 225. The LED driver 220 is typically provided as a dedicated driver apparatus, embodied by hardware means or as combination of hardware means and software means. The LED driver 220 and/or the driver apparatus may comprise further components, portions or units in addition to those described herein. However, role and operation of such components of a LED driver is well known in the art and falls outside the scope of the present invention. Alternatively, the arrangement of components depicted in Figure 3 may be considered as use of the pulse control portion 230 for providing the dimming control signal 235 for a LED driving arrangement (or a LED driving apparatus) comprising the driving portion 240 and the power converter portion 250 (possibly together with further components, portions our units typically applied in a LED driver).

In case the input control signal 205 is provided as commands or requests in accordance with a lighting control protocol, the LED driver 220 may optionally comprise a dimming control interface 212 for generating the PWM control signal 215 on basis of the input control signal 205, e.g. by converting the input control signal 205 into the PWM control signal 215. In such a scenario the input control signal 205 may serve as an input signal to the LED driver instead of the PWM control signal 215 (as depicted in Figure 2). Alternatively, the dimming control interface 212 may be (conceptually) provided as part of the controller entity 210 and hence outside the LED driver 220, thereby making the PWM control signal 215 as an input signal to the LED driver 220 (instead of the input control signal 205).

The dimming control interface 212 is configured to derive the PWM control signal 215 in accordance with the command or request received in the input control signal 205. The dimming control interface 212 is, preferably, configured to generate the PWM control signal 215 and set the duty cycle *D*_{ctrl} of the PWM control signal 215 in accordance with a command or request received in the input control signal 205. This may comprise the dimming control interface 212 to be configured to apply a predetermined mapping, e.g. by employing a mapping function, to convert the requested light intensity level into the corresponding duty cycle *D*_{ctrl}. The requested light intensity level may be indicated e.g. as the desired percentage of the maximum light intensity level *L*_{req}. Consequently, the mapping function may cause the dimming control interface 212 to set the duty cycle *D*_{ctrl} of the PWM control signal 215 to *D*_{ctrl} = *L*_{req}. Hence, in such an arrangement the applied duty cycle *D*_{ctrl} typically directly indicates the desired light intensity level as a percentage of the maximum light intensity level. Such control of light intensity level in LED drivers is well known in the art.

The power converter portion 250 is configured to provide the driving current 255 in accordance with the driving signal 245. The power converter portion 250 comprises a switched-mode power converter entity configured to convert the operating power 217 provided as input thereto at a first voltage into the driving current 255. A number of different switched-mode power converters suitable for operating as the power converter entity of the power converter portion 250 are known in the art. Non-limiting examples of suitable types of power converter portion include a buck converter, a boost converter, a flyback converter, a half-bridge, etc.

The driving portion 240 may be configured to control provision of the driving current 255 by issuing the driving signal 245. Consequently, the power converter portion 250 may be configured to convert the operating power 217 supplied thereto into the driving current 255 in accordance with the driving signal 245. The driving portion 240 is typically provided as an integrated circuit (IC) or as a processor (such as a microprocessor or a microcontroller) In this regard, the driving portion 240 may be arranged to operate a switch of a switched-mode power converter entity by alternately closing and opening the switch at a high switching frequency (which is typically in range of tens of kilohertz) that depends on the load (e.g. the LED light source 270) driven by the switched-mode power converter entity. The timing of opening and closing of the switch is controlled on basis of a current measurement signal received at the driving portion 240, the current measurement signal indicating the observed level of the driving current 255. As an example in this regard, the driving portion 240 may be configured to close the switch in response to the current measurement signal indicating current that is lower than or equal to a low current threshold *I*_{TH}_ₗₒ, thereby causing gradual increase in the output current of the switched-mode power converter. In contrast, the driving portion 240 may be further configured to open the switch in response to the current measurement signal indicating current that is higher than a high current threshold *I*_{TH_hi,} thereby causing gradual decrease in the output current of the switched-mode power converter. Consequently, the current is caused to (quasi-periodically) vary within bounds defined by the current thresholds *I*_{TH_lo} and *I*_{TH}_ₕᵢ.

The current thresholds *I*_{TH_lo} and *I*_{TH_hi} are set in accordance with a target current *I*_{tgt} e.g. such the high current threshold *I*_{TH_hi} may be set to a value that slightly exceeds the target current *I*_{tgt}, while the low current threshold *I*_{TH_lo} is set to a value that is slightly smaller than the target current *I*_{tgt}. Consequently, if the target current *I*_{tgt} is kept constant, the average level or the rms level of the driving current 255 approximates the target current *I*_{tgt}.

The driving portion 240 may be configured to enable and disable the provision of the driving current 255 from the power converter portion 250 in accordance with the voltage of the dimming control signal 235 to implement the PWM dimming technique. This may involve the driving portion 240 controlling the power converter portion 250 to disable provision of the driving current 255 in response to the dimming control signal 235 exhibiting voltage that is smaller than or equal to a predetermined low voltage threshold *V*_{TH_lo} (i.e. in response to a non-active period of the dimming control signal) and to enable provision of the driving current 255 in response to the dimming control signal 235 exhibiting voltage that is larger than the low voltage threshold *V*_{TH_lo} (i.e. in response to an active period of the dimming control signal). Alternatively, the operation logic of the driving portion 240 in this regard may be the opposite from the one described above: the driving portion 240 may be configured to disable provision of the driving current 255 in response to the dimming control signal 235 exhibiting voltage that is larger than or equal to the predetermined high voltage threshold *V*_{TH_lo} and to enable provision of the driving current 255 in response to the dimming control signal 235 exhibiting voltage that is smaller than the low voltage threshold *V*_{TH_lo}.

The dimming control signal 235 applied to control PWM dimming does not necessarily have to be a pure PWM signal, but any signal comprising alternating active periods (e.g. exhibiting voltage that is higher than or equal to the low voltage threshold *V*_{TH_lo}) and non-active periods (e.g. exhibiting voltage that is smaller than the low voltage threshold *V*_{TH_lo}, preferably zero or essentially zero) qualifies as the dimming control signal 235. Consequently, the power converter portion 250 provides the output current 255 exhibiting alternating periods of zero current (when disabled) and periods of the driving current 255 approximating the target current *I*_{tgt} (when enabled).

The driving portion 240 may be configured to enable analog control of the instantaneous level of the driving current 255, i.e. to enable analog dimming. In this regard, the driving portion 240 may be further configured to control the instantaneous level of the driving current 255 in accordance with the characteristics of the dimming control signal 235. To this end, the driving portion 240 may be configured to control the target current *I*_{tgt} in accordance with the dimming control signal 235, e.g. in accordance with the instantaneous voltage of the dimming control signal 235.

The analog dimming may be implemented for example by the driving portion setting the low and high current thresholds *I*_{TH_lo} and *I*_{TH_hi} such that the desired target current *I*_{tgt} is provided. The driving portion 240 is preferably configured to set or adjust the thresholds *I*_{TH_lo} and *I*_{TH_hi} only in response to the driving signal 235 exhibiting instantaneous voltage exceeding the low voltage threshold *V*_{TH_lo}, i.e. voltage that results in enabling the provision of the driving current 255 from the power converter portion 250.

The driving portion 240 may be configured to control the power converter portion 250 to provide the driving current 255 at an intermediate level that is in the range between a predetermined minimum level *I*ₘᵢₙ and a predetermined maximum level *I*ₘₐₓ. The applied intermediate level is proportional to the voltage of the dimming control signal 235, in other words the intermediate level increases with increasing voltage of the dimming control signal 235 (and, in contrast, decreases with decreasing voltage of the dimming control signal 235). In particular, the applied intermediate level may be directly proportional or essentially directly proportional to the voltage of the dimming control signal 235.

Moreover, the driving portion 240 may be further configured to control the power converter portion 250 to provide the driving current 255 at the maximum level *I*ₘₐₓ in response to the dimming control signal 235 exhibiting voltage that is higher than or equal to a predetermined high voltage threshold *V*_{TH_hi} and/or to control the power converter portion 250 to disable provision of the driving current 255 in response to the dimming control signal 235 exhibiting voltage that is lower than or equal to the low voltage threshold *V*_{TH_lo}. Furthermore, the driving portion 240 may be further configured to control the power converter portion 250 to provide the driving current 255 at the intermediate level in response to the dimming control signal 235 exhibiting voltage that is between the low voltage threshold *V*_{TH_lo} and the high voltage threshold *V*_{TH}_ₕᵢ.

Alternatively (as described for the PWM dimming technique above), the relationship between the voltage of the dimming control signal 235 and the resulting output current 255 may be the opposite of that of the above example. In other words, the driving portion 240 may be configured to control the power converter portion 250 to provide the driving current 255 at the intermediate level that is inversely proportional to the voltage of the dimming control signal 235, in other words the intermediate level increases with decreasing voltage of the dimming control signal 235 (and, in contrast, decreases with increasing voltage of the dimming control signal 235). Consequently, in such a scenario the driving portion 240 may be further configured to control the power converter portion 250 to provide the driving current 255 at the maximum level *I*ₘₐₓ in response to the dimming control signal 235 exhibiting voltage that is smaller than or equal to a predetermined low voltage threshold *V*_{TH_lo} and/or to control the power converter portion 250 to disable provision of the driving current 255 in response to the dimming control signal 235 exhibiting voltage that is higher than or equal to the high voltage threshold *V*_{TH_hi}, while controlling the power converter portion 250 to provide the driving current 255 at the intermediate level in response to the dimming control signal 235 exhibiting voltage that is between the low voltage threshold *V*_{TH_lo} and the high voltage threshold *V*_{TH}_ₕᵢ.

The pulse shaping portion 230 is configured to generate the dimming control signal 235 on basis of the PWM control signal 215. Herein, the PWM control signal 215 is considered as PWM signal in a broad sense, encompassing control signals exhibiting a pulse train of square wave pulses or pulses having essentially square wave shape. The pulse shaping portion 230 is configured to process the PWM control signal 215 into the dimming control signal 235 such that the rate (or speed) at which the voltage in the leading edge of pulses of the signal rises towards its maximum value is reduced (in comparison to that of the PWM control signal 215). In particular, the pulse shaping portion 230 may be configured to provide the dimming control signal 235 where the rate (or speed) at which the voltage in the beginning of pulses rises from the low voltage threshold *V*_{TH_lo} (or from zero voltage) to the high voltage threshold *V*_{TH_hi} is reduced. The resulting decrease in the slope of the rising edges of the pulses, which may also be referred to as softening of the rising edges of the pulses, may hence be applied to cause the rise time in pulses of the dimming control signal 235 to be longer (or slower) than the rise time in the pulses of the PWM control signal 215.

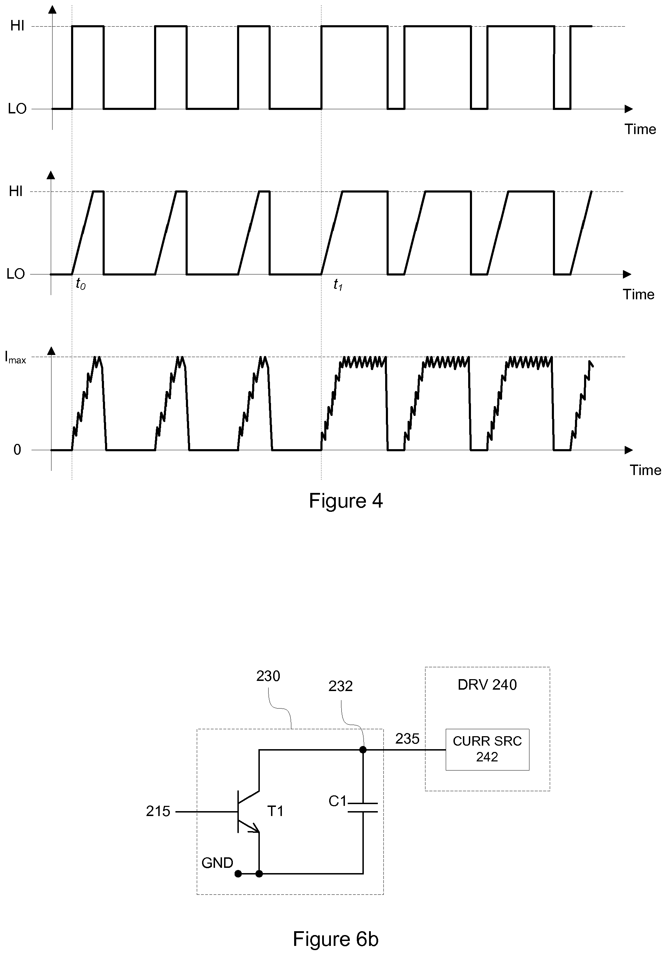

An example of the concept of providing the dimming control signal 235 on basis of the PWM control signal 215 together with the resulting driving current 255 is provided in Figure 4, where the uppermost curve shows an exemplifying PWM control signal 215, the second curve (from the top) shows a respective dimming control signal 235 derived on basis of this PWM control signal, and the lowermost curve shows the resulting driving current 255. In this example, from time *t₀* until time *t₁* the PWM control signal applies duty cycle of (approx.) 30 %, whereas from time *t₁* onwards the PWM control signal applies duty cycle of (approx.) 80 %. As can be seen in Figure 4, the softened rising edges of the pulses of the dimming control signal 235 slow down the rate of the current level rising towards the maximum level *I*ₘₐₓ in the corresponding portion of the driving current 255. This is due to the operation of the driving portion 240, controlling the power converter portion 250 to provide the driving current 255 at the minimum level *I*ₘᵢₙ once the voltage of the dimming control signal 235 has reached the low voltage threshold *V*_{TH_lo} and controlling the power converter portion 250 to increase the level of the driving current 255 with the increasing voltage of the diming control signal 235 until reaching the maximum level *I*ₘₐₓ.. Subsequently, upon completion of the pulse of the dimming control signal 235, the driving portion 240 temporarily disables the provision of the driving current 255 from the power converter portion 250 (or temporarily sets the driving current 255 to a zero current) until the next pulse of the dimming control signal 235. Consequently, due to softened rising edges of the dimming control signal 235 the resulting average current is a smaller portion of the maximum current level *I*ₘₐₓ than indicated by the duty cycle *D*_{ctrl} of the PWM control signal 215 (whereas in the case of pure PWM dimming the resulting average current typically approximates *D*_{ctrl} x *I*ₘₐₓ). To exemplify this effect, the duty cycle of (approx.) 30 % applied from time *t₀* until time *t₁* can be assumed to result in average driving current 255 that is (approx.) 25 % of the maximum level *I*ₘₐₓ, wherein the duty cycle of (approx.) 80 % can be assumed to result in average driving current 255 that is (approx.) 75 % of the maximum level *I*ₘₐₓ., thereby resulting in driving current(s) 255 similar to those in the examples of Figures 1a and 1b. The mapping between the duty cycle of the PWM control signal 215 and the percentage of the maximum current level *I*ₘₐₓ that is descriptive of the average level of the driving current 255 is dependent on the characteristics of the pulse shaping portion 230. Therefore, the mapping function applied in the dimming control interface 212 for converting the requested light intensity into the corresponding duty cycle of the PWM control signal 215 is configured to account for the characteristics of the pulse shaping portion 230.

As an example in this regard, one may assume that in the beginning of pulses of dimming control signal 235 the voltage increases at a constant or essentially constant rate, that the rise time for the voltage to rise from the low voltage threshold *V*_{TH_lo} to the high voltage threshold *V*_{TH_hi} is *t*ₓ, and that the voltage stays at or above the high threshold *V*_{TH_hi} until the end of the pulse. Further assuming that the overall duration of pulse (when the voltage is at or above *V*_{TH}_ₕᵢ) is *t*ₐ and that the overall duration of the cycle is *t*_{c}, the driving current 255 can be assumed to rise linearly from zero to *I*ₘₐₓ during the time period *t*ₓ in the beginning of a pulse, to stay at *I*ₘₐₓ until the end of the pulse, and to drop to zero at the end of the pulse. Consequently, if denoting *a* = *t*ₓ / *t*_{c} and *b* = *tₐ* / *t*_{c}, the average current of the cycle (and over a sequence of such cycles) becomes *I*_{avg} = (*b - a*/2) x *I*ₘₐₓ. Hence, in in order to provide the dimming control signal 235 resulting in an average current that is *L*_{req} times the maximum current *I*ₘₐₓ (i.e. *L*_{req} x *I*ₘₐₓ), the PWM control signal 215 should exhibit the duty cycle *D*_{ctrl} = *L*_{req} + *a*/2. This mapping between the requested light intensity *L*_{req} and the duty cycle *D*_{ctrl} is applicable to requested light intensities *L*_{req} that are larger than or equal to *a*/2. The duration of the time period *t*ₓ and hence the value of *a* may be e.g. derived on basis of the characteristics of the pulse shaping portion 230 and/or it may be determined on experimental basis. As an example, if the desired percentage of the maximum light intensity is 25 % (i.e. *L*_{req} = 0.25) and *I*ₘₐₓ is reached after 10 % of a pulse duration (i.e. *a* = 0.1), the duty cycle *D*_{ctrl} for the PWM control signal 215 should be set to *D*_{ctrl} = 0.25 + 0.1 / 2 = 0.3.

While the above logic describes the relationship between the requested light intensity *L*_{req} and the required duty cycle *D*_{ctrl} for the case where pulse duration of the PWM control signal 215 is long enough to enable reaching the maximum current *I*ₘₐₓ, i.e. longer than *t*ₓ, the relationship is slightly different in the case where pulse duration is shorter than *t*ₓ. In this case the current reached before termination of the pulse is *b*/*a* x *I*ₘₐₓ (where *b* < *a*) and hence the average current over a pulse is *b*/(2*a*) x *I*ₘₐₓ and the average current over the cycle (and over a sequence of such cycles) is *b*²/(2*a*) x *I*ₘₐₓ. Hence, in order to provide the dimming control signal 235 resulting in an average current that is *L*_{req} times the maximum current *I*ₘₐₓ (i.e. *L*_{req} x *I*ₘₐₓ), the PWM control signal 215 should exhibit the duty cycle *D*_{ctrl} = sqrt(2*a* x *L*_{req}), where sqrt() denotes the square root operation. This mapping between the requested light intensity *L*_{req} and the duty cycle *D*_{ctrl} is applicable to requested light intensities *L*_{req} that are smaller than or equal to a/2. As an example, if the desired percentage of the maximum light intensity is 4 % (i.e. *L*_{req} = 0.04) and *a* = 0.1, the duty cycle *D*_{ctrl} for the PWM control signal 215 should be set to *D*_{ctrl} = sqrt(2 x 0.1 x 0.04) ≈ 0.089.

Alternatively, especially in case the voltage in the beginning of the pulses increases at non-constant rate, the mapping between the duty cycle *D*_{ctrl} and the resulting average driving current 255 may be determined on experimental basis e.g. by applying a set of duty cycles covering a range of interest and measuring the resulting average driving currents 255, thereby providing pairs of a duty cycle and the corresponding average driving current 255 that define the mapping.

As Figure 4 demonstrates, the dimming control signal 235 with softened rising edges of the pulses results in the driving current 255 having an envelope that approximates that of the dimming control signal 235. In comparison to pure PWM dimming, this approach results in increased pulse width and hence decreased distances between consecutive pulses when providing the driving current 255 resulting in a certain light intensity level, thereby contributing to reduced perceivable flickering of light due to unnecessarily sparsely provided pulses in the driving current 255 in the low end of the light intensity levels. Moreover, gradually increasing driving current 255 in the beginnings of pulses enable more accurate adjustment of the light intensity level especially in low light intensity levels. On the other hand, at the same time this approach avoids the complexity of the hybrid dimming while providing performance that is equivalent to that of the hybrid dimming in terms of (avoiding) the flickering of light and (avoiding) perceivable steps in the light intensity change at low light intensity levels.

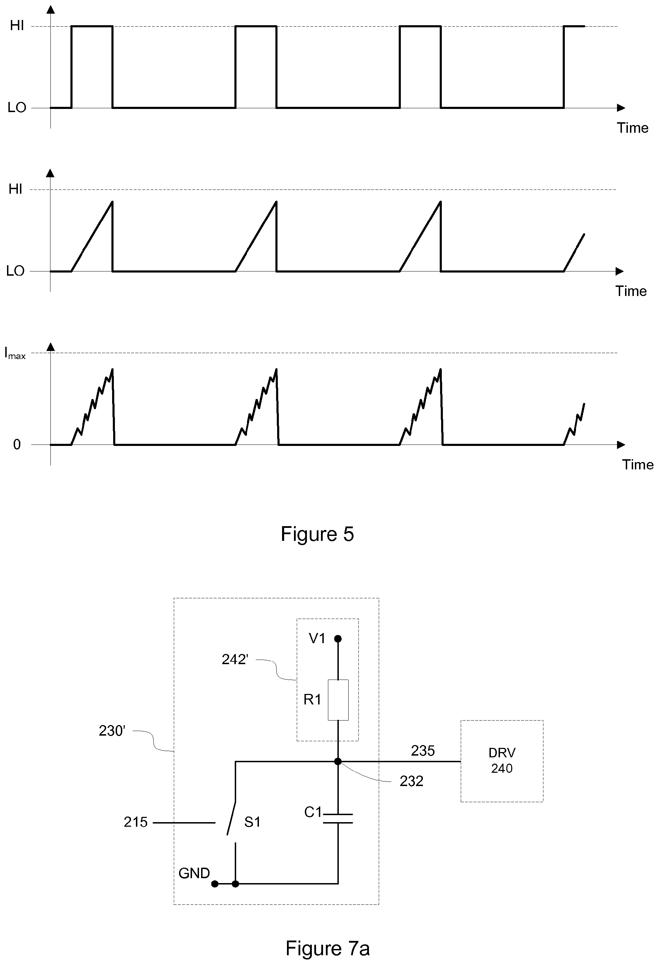

Figure 5 provides another example of the dimming control signal 235 with softened rising edges of the pulses. The difference to the example of Figure 4 is that this example demonstrates the effect of (even) lower light intensity levels. In the example of Figure 5, the duty cycle of the PWM control signal 215 (the uppermost curve) is approx. 20 %. Due to softened rising edges of pulses and to relatively low duty cycle, the voltage level in pulses of the dimming control signal 235 (the second curve from the top) does not reach the high voltage threshold *V*_{TH_hi} before completion of the pulses. Consequently, in the driving current 255 (the lowermost curve) derived on basis of such dimming control signal do not reach the maximum current level *I*ₘₐₓ either.

The pulse shaping portion 230 may comprise an arrangement of a switch S1 and a capacitor C1 connected in parallel and arranged between the source of the PWM control signal 215 and an input of the driving portion 240, as depicted in example illustrated in Figure 6a. The PWM control signal 215 is coupled to control the switch S1, and the low sides of the switch S1 and the capacitor C1 are coupled to a ground potential GND. The high sides of the switch S1 and the capacitor C1 are connected to a node 232, which is coupled to the driving portion 240, hence providing the dimming control signal 235 as an output of the pulse shaping portion 230. The capacitor C1 is configured to receive a charging current via the node 232. The charging current is, preferably, provided as a constant current in order to cause the voltage in the beginnings of pulses of the dimming control signal 235 to increase at constant or essentially constant rate (i.e. to increase linearly over time), thereby facilitating straightforward mapping between the duty cycle in the PWM control signal 215 and the respective average level of the driving current 255 (e.g. as a percentage of the maximum current level *I*ₘₐₓ). The switch S1 is arranged to control provision of the voltage from the capacitor C1 as the dimming control signal 235 (as the output of the pulse shaping portion 230) in accordance with the PWM control signal 215 (serving as an input signal to the pulse shaping portion 230) The extent of slowing down is defined by the characteristics, e.g. the capacitance, of the capacitor. Hence, the capacitor C1 may be selected, in view of characteristics of the other components of the LED driver 220, e.g. such that the rise time of pulses of the dimming control signal 235 is set (e.g. slowed down) to a desired value or such that a desired extent of decrease in rise time in pulses of the dimming control signal 235 (in comparison to pulses PWM control signal 215) is provided.

As an example, the switch S1 of the pulse shaping portion 230 may be provided e.g. as a Bipolar Junction Transistor (BJT) transistor or as a Field Effect Transistor (FET) of suitable characteristics. Figure 6b schematically illustrates a variant of the pulse shaping portion 230 of Figure 6a employing a npn-type BJT T1 as the switch S1. In the example of Figure 6b, the PWM control signal 215 is coupled to the base of the BJT T1, while the emitter of the BJT T1 is coupled to the ground potential GND and the collector of the BJT T1 is coupled to the node 232. A first terminal of the capacitor C1 is connected to the node 232 while a second terminal of the capacitor is coupled to the ground potential GND. Moreover, the current source 242 is coupled to the node 232 to provide the charging current to the first terminal capacitor C1.

The driver 220 may further comprise charging means coupled to the capacitor C1 and configured to continuously charge the capacitor C1 by the charging current (preferably a constant charging current). In the examples of Figures 6a and 6b the charging means is provided by a current source 242 provided in the driving portion 240. As another example, the charging means may be provided as a dedicated charging arrangement outside the driving portion 240, e.g. as a current source outside the driving portion 240, coupled to the capacitor C1 via the node 232 and arranged to provide the charging current. As an example in this regard, Figure 7a schematically illustrates a pulse shaping portion 230' as a variation of the pulse shaping portion 230. The pulse shaping portion 230' comprises a dedicated charging arrangement 242', which comprises a voltage source V1 coupled to the node 232 and hence to the capacitor C1 via a resistor R1. The arrangement of the switch S1 and the capacitor C1 as well as operation of the arrangement is similar to that described in context of Figures 6a and 6b. While the structure of the pulse shaping portion 230' is rather straightforward, it is not able to provide a constant charging current (to the capacitor C1), thereby possibly making the mapping between the duty cycle of the PWM control signal 215 and the percentage of the maximum current level *I*ₘₐₓ that is descriptive of the average level of the driving current 255 slightly more complex than e.g. in the example of Figure 6b.

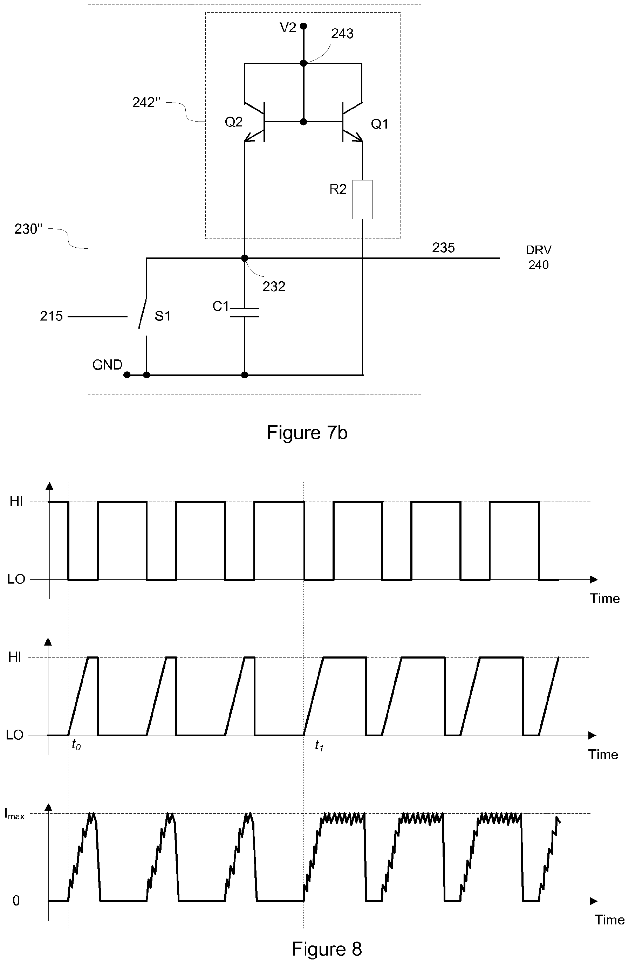

Figure 7b schematically illustrates a pulse shaping portion 230", serving as another example of a pulse shaping portion provided outside the driving portion 240. The pulse shaping portion 230" comprises a dedicated charging arrangement 242", which comprises a current mirror formed by the BJTs Q1 and Q2. The bases of the BJTs Q1 and Q2 are connected to each other and further coupled to a node 243. The collectors of the BJTs Q1 and Q2 are also connected to the node 243, and hence connected to each other. The node 243 is coupled to the voltage source V2. The emitter of the BJT Q1 is coupled via a resistor R2 to the ground potential GND, and the emitter of the BJT Q2 is coupled to the high side of the capacitor C1 via the node 232. The arrangement of the switch S1 and the capacitor C1 as well as operation of the arrangement is similar to that described in context of Figures 6a and 6b. The pulse shaping portion 230" is able to provide a constant charging current, thereby enabling relatively straightforward mapping between the duty cycle of the PWM control signal 215 and the percentage of the maximum current level *I*ₘₐₓ that is descriptive of the average level of the driving current 255.

The arrangement of the capacitor C1 and the switch S1 connected in parallel exemplified by circuits of Figure 6 and 7 is arranged to provide the dimming control signal 235 such that when the PWM control signal 215 is in active state (in 'high' state during a pulse of the PWM control signal 215, e.g. exhibiting a voltage exceeding a predefined threshold), the switch S1 is closed and electric current flows via the switch S1, and the voltage at the high side of the capacitor S1 is a (low) voltage that depends on characteristics of the switch S1. Consequently, the dimming control signal 235 at low voltage is provided. E.g. in case the switch S1 is provided as a BJT, this voltage is the threshold voltage of the BJT. In contrast, when the PWM control signal 215 is in non-active state (in 'low' state between pulses of the PWM control signal 215, e.g. exhibiting a voltage not exceeding the predefined threshold) the electric current flows via the capacitor C1, thereby charging the capacitor C1. This results in the voltage at the high side of the capacitor C1 to gradually increase towards a maximum value that depends on characteristics (e.g. capacitance) of the capacitor C1. Consequently, the dimming control signal 235 of gradually increasing voltage is provided. Once the PWM control signal 215 is again switched to the active state (to commence the next pulse of the PWM control signal 215), the capacitor C1 is quickly discharged and the resulting dimming control signal 235 is again provided at the low voltage.

In other words, the pulse shaping portion according to Figures 6a, 6b, 7 in practice operates to invert the PWM controls signal 215 such that active periods (i.e. pulses) of the PWM control signal 215 are converted into non-active periods (i.e. periods between pulses) of the dimming control signal 235 while at the same time causing the rise time in pulses of the dimming control signal 235 to be longer (or slower) than the rise time in the pulses of the PWM control signal 215. Figure 8 illustrates this effect by showing an exemplifying PWM control signal 215 (the topmost curve) which is an inverse of that of the example of Figure 4, whereas the resulting dimming control signal 235 (the second curve from the top) and the driving current 255 (the lowermost curve) are similar to those of the example of Figure 4. Due the pulse control portion 230 e.g. according to Figures 6a, 6b, 7 inverting the pulses of the PWM control signal 215, the dimming control interface 212 must be configured, in view of such 'inverting' behavior of the pulse shaping portion 230, to apply a mapping function that takes both the 'inversion' of the pulses and the softening of the rising edges of pulses into account in determination of the duty cycle *D*_{ctrl} for the PWM control signal 215 on basis of the desired light intensity level *L*_{req}.

In case of constant charging current it can be assumed that the voltage in the beginning of pulses of the dimming control signal 235 increases from the low voltage threshold *V*_{TH_lo} to the high voltage threshold *V*_{TH_hi} at constant or essentially constant rate. Hence, to account for the 'inversion' of the pulses, in case the pulse duration of the PWM control signal 215 is longer than or equal to *t*ₓ, in order to provide an average current that is *L*_{req} times the maximum current *I*ₘₐₓ, the mapping between the requested light intensity level *L*_{req} the duty cycle *D*_{ctrl} of the PWM control signal 215 may be determined e.g. as *D*_{ctrl} = 100 % - *L*_{req} - *a*/2, where the term '100 % - *L*_{req}' represents the 'inversion' of the pulses of the PWM control signal 215 in the pulse shaping portion 230 while the term *a*/2 represents the contribution of the softening of the rising edges of pulses (as described hereinbefore in more detail). In case the pulse duration of the PWM control signal 215 is shorter than *t*ₓ required to reach the maximum current Imax, the mapping between the requested light intensity level *L*_{req} the duty cycle *D*_{ctrl} of the PWM control signal 215 may be determined e.g. as *D*_{ctrl} = 100 % - sqrt(2*a* x *L*_{req}). Alternatively, determination of the mapping between the duty cycle *D*_{ctrl} and the resulting average driving current 255 on experimental basis described hereinbefore may be applied also for the case where the pulse control portion 230 'inverts' the pulses of the PWM control signal 215 in the process of generating the dimming control signal 235.

## Claims

1. An apparatus (220) for providing a driving current (255) for one or more light emitting diodes (270), the apparatus comprising
a power converter portion (250) comprising a switched-mode power converter entity for converting operating power (217) supplied to the apparatus (220) into the driving current (255) in accordance with a driving signal (245),
a driving portion (240) for generating the driving signal (245) for controlling provision of the driving current (255) from the power converter portion (250) in accordance with the voltage of a dimming control signal (235), the driving portion (240) further arranged to alternately close and open a first switch of said switched-mode power converter entity at a switching frequency, and
a pulse shaping portion (230, 230', 230") for generating the dimming control signal (235) on basis of a PWM signal (215) that has a lower frequency than said switching frequency,
**characterized in that** the pulse shaping portion (230, 230', 230") comprises
- a capacitor (C1) configured to receive a charging current, and
- a second switch (S1) connected in parallel with the capacitor (C1), the second switch (S1) arranged to control provision of the charge from the capacitor (C1) as the dimming control signal (235) in accordance with the PWM signal (215),
the apparatus comprises a charging means (242, 242', 242") coupled to the capacitor (C1), the charging means configured to continuously charge the capacitor (C1) by a constant charging current,
the pulse shaping portion (230, 230', 230") thereby arranged to derive pulses of the dimming control signal (235) on basis of the PWM signal (215) such that rise time in the pulses of the dimming control signal (235) is longer than that of the pulses of the PWM signal (215) to provide an average driving current (255) that is a smaller portion of a maximum current level (*I*ₘₐₓ) than indicated by the duty cycle of the PWM signal (215).

2. An apparatus according to claim 1, wherein the driving portion (240) comprises a current source (242) configured to operate as the charging means.

3. An apparatus according to claim 1, wherein the pulse shaping portion (230') comprises a charging arrangement (242') comprising a voltage source (V1) coupled to the capacitor (C1) via a resistor (R1), said charging arrangement (242') configured to operate as the charging means.

4. An apparatus according to claim 1, wherein the pulse shaping portion (230") comprises a charging arrangement (242") comprising a current mirror coupled to a voltage source (V2), said charging arrangement (242") configured to operate as the charging means.

5. An apparatus according to any of claims 1 to 4, wherein the driving portion (240) is configured to control the power converter portion (250) to provide the driving current (255) at an intermediate level that is in the range between a predetermined minimum level and a predetermined maximum level and which intermediate level is proportional or inversely proportional to the voltage of the dimming control signal (235).

6. An apparatus according to claim 5, wherein the driving portion (240) is further configured to
control the power converter portion (250) to disable provision of the driving current (255) in response to the dimming control signal (235) exhibiting voltage that is smaller than or equal to a predetermined low threshold,
control the power converter portion (250) to provide the driving current (255) at said predetermined maximum level in response to the dimming control signal (235) exhibiting voltage that is larger than or equal to a predetermined high threshold, and
control the power converter portion (250) to provide the driving current (255) at the intermediate level in response to the dimming control signal (235) exhibiting voltage that is between the low and high thresholds.

7. An apparatus according to claim 5, wherein the driving portion (240) is further configured to
control the power converter portion (250) to disable provision of the driving current (255) in response to the dimming control signal (235) exhibiting voltage that is larger than or equal to a predetermined high threshold,
control the power converter portion (250) to provide the driving current (255) at said predetermined maximum level in response to the dimming control signal (235) exhibiting voltage that is smaller than or equal to a predetermined low threshold, and
control the power converter portion (250) to provide the driving current (255) at the intermediate level in response to the dimming control signal (235) exhibiting voltage that is between the low and high thresholds.

8. An apparatus according to any of claims 1 to 7, wherein said second switch (S1) is provided as a bipolar junction transistor, BJT, and wherein the PWM signal (215) is coupled to the base of the BJT,
the emitter of the BJT is coupled to a ground potential,
the collector of the BJT is coupled to an output node (232) for providing the dimming control signal (235),
a first terminal of the capacitor (C1) is coupled to said output node (232), and
a second terminal of the capacitor (C1) is coupled to the ground potential.

9. Use of a pulse shaping portion (230, 230', 230") to provide a dimming control signal (235) for an apparatus for providing a driving current (255) for one or more light emitting diodes (270), the apparatus comprising a power converter portion (250) comprising a switched-mode power converter entity for converting operating power (217) supplied to the apparatus into the driving current (255) in accordance with a driving signal (245) and a driving portion (240) for controlling provision of the driving current (255) from the power converter portion (250) in accordance with the voltage of the dimming control signal (235), the driver portion (240) further arranged to alternately close and open a first switch of said switched-mode power converter entity at a switching frequency,
during which use the pulse shaping portion (230, 230', 230") generates the dimming control signal (235) on basis of a PWM signal (215) that has a lower frequency than said switching frequency,
and during which use a capacitor (C1) comprised in the pulse shaping portion (230, 230', 230") receives a charging current from a charging means (242, 242', 242") coupled to the capacitor (C1), which charging means (242, 242', 242") is configured to continuously charge the capacitor (C1) by a constant charging current,
and during which use a second switch (S1) connected in parallel with the capacitor (C1) controls provision of the charge from the capacitor (C1) as the dimming control signal (235) in accordance with the PWM signal (215),
and during which use the pulse shaping portion (230, 230', 230") thereby derives pulses of the dimming control signal (235) on basis of the PWM signal (215) such that rise time in the pulses of the dimming control signal (235) is longer than that of the pulses of the PWM signal (215) to provide an average driving current (255) that is a smaller portion of a maximum current level (*I*ₘₐₓ) than indicated by the duty cycle of the PWM signal (215).

## Patentansprüche

1. Vorrichtung (220) zum Bereitstellen eines Ansteuerstroms (255) für eine oder mehrere Leuchtdioden (270), wobei die Vorrichtung Folgendes umfasst:
einen Leistungsumsetzungsabschnitt (250), der eine Leistungsumsetzungseinheit im Schaltmodus zum Umsetzen der Betriebsleistung (217), die der Vorrichtung (220) zugeführt wird, in den Ansteuerstrom (255) in Übereinstimmung mit einem Ansteuersignal (245) umfasst,
einen Ansteuerabschnitt (240) zum Erzeugen des Ansteuersignals (245) zum Steuern der Bereitstellung des Ansteuerstroms (255) von dem Leistungsumsetzungsabschnitt (250) in Übereinstimmung mit der Spannung eines Dimm-Steuersignals (235), wobei der Ansteuerabschnitt (240) ferner ausgelegt ist, einen ersten Schalter der Leistungsumsetzungseinheit im Schaltmodus mit einer Schaltfrequenz abwechselnd zu schließen und zu öffnen, und
einen Pulsformungsabschnitt (230, 230', 230") zum Erzeugen des Dimm-Steuersignals (235) auf der Grundlage eines PWM-Signals (215), das eine niedrigere Frequenz als die Schaltfrequenz aufweist,
**dadurch gekennzeichnet, dass** der Pulsformungsabschnitt (230, 230', 230") Folgendes umfasst:
- einen Kondensator (C1), der konfiguriert ist, einen Ladestrom zu empfangen, und
- einen zweiten Schalter (S1), der zum Kondensator (C1) parallelgeschaltet ist, wobei der zweite Schalter (S1) ausgelegt ist, die Bereitstellung der Ladung von dem Kondensator (C1) als das Dimm-Steuersignal (235) in Übereinstimmung mit dem PWM-Signal (215) zu steuern,
die Vorrichtung Lademittel (242, 242', 242") umfasst, die an den Kondensator (C1) gekoppelt sind, wobei die Lademittel konfiguriert sind, den Kondensator (C1) durch einen konstanten Ladestrom kontinuierlich zu laden,
wobei der Pulsformungsabschnitt (230, 230', 230") dabei ausgelegt ist, Pulse des Dimm-Steuersignals (235) auf der Grundlage des PWM-Signals (215) abzuleiten, so dass die Anstiegszeit in den Pulsen des Dimm-Steuersignals (235) länger als die der Pulse des PWM-Signals (215) ist, um einen mittleren Ansteuerstrom (255) bereitzustellen, der einem kleineren Anteil eines maximalen Strompegels (Iₘₐₓ) entspricht als durch das Tastverhältnis des PWM-Signals (215) angezeigt wird.

2. Vorrichtung nach Anspruch 1, wobei der Ansteuerabschnitt (240) eine Stromquelle (242) umfasst, die konfiguriert ist, als die Lademittel zu arbeiten.

3. Vorrichtung nach Anspruch 1, wobei der Pulsformungsabschnitt (230') eine Ladeanordnung (242') umfasst, die eine Spannungsquelle (V1) umfasst, die über einen Widerstand (R1) an den Kondensator (C1) gekoppelt ist, wobei die Ladeanordnung (242') konfiguriert ist, als die Lademittel zu arbeiten.

4. Vorrichtung nach Anspruch 1, wobei der Pulsformungsabschnitt (230") eine Ladeanordnung (242") umfasst, die einen Stromspiegel umfasst, der an eine Spannungsquelle (V2) gekoppelt ist, wobei die Ladeanordnung (242") konfiguriert ist, als die Lademittel zu arbeiten.

5. Vorrichtung nach einem der Ansprüche 1 bis 4, wobei der Ansteuerabschnitt (240) konfiguriert ist, den Leistungsumsetzungsabschnitt (250) zu steuern, den Ansteuerstrom (255) auf einem mittleren Pegel, der sich in dem Bereich zwischen einem vorgegebenen minimalen Pegel und einem vorgegebenen maximalen Pegel befindet, bereitzustellen, wobei der mittlere Pegel proportional oder umgekehrt proportional zu der Spannung des Dimm-Steuersignals (235) ist.

6. Vorrichtung nach Anspruch 5, wobei der Ansteuerabschnitt (240) ferner konfiguriert ist,
den Leistungsumsetzungsabschnitt (250) zu steuern, das Bereitstellen des Ansteuerstroms (255) als Reaktion auf das Dimm-Steuersignal (235), das eine Spannung zeigt, die kleiner oder gleich einem vorgegebenen niedrigen Schwellenwert ist, auszuschalten,
den Leistungsumsetzungsabschnitt (250) zu steuern, den Ansteuerstrom (255) auf dem vorgegebenen maximalen Pegel bereitzustellen als Reaktion auf das Dimm-Steuersignal (235), das eine Spannung zeigt, die größer oder gleich einem vorgegebenen hohen Schwellenwert ist, und
den Leistungsumsetzungsabschnitt (250) zu steuern, den Ansteuerstrom (255) auf dem vorgegebenen mittleren Pegel bereitzustellen als Reaktion auf das Dimm-Steuersignal (235), das eine Spannung zeigt, die zwischen dem niedrigen und dem hohen Schwellenwert liegt.

7. Vorrichtung nach Anspruch 5, wobei der Ansteuerabschnitt (240) ferner konfiguriert ist,
den Leistungsumsetzungsabschnitt (250) zu steuern, das Bereitstellen des Ansteuerstroms (255) als Reaktion auf das Dimm-Steuersignal (235), das eine Spannung zeigt, die größer oder gleich einem vorgegebenen hohen Schwellenwert ist, auszuschalten,
den Leistungsumsetzungsabschnitt (250) zu steuern, den Ansteuerstrom (255) auf dem vorgegebenen maximalen Pegel bereitzustellen als Reaktion auf das Dimm-Steuersignal (235), das eine Spannung zeigt, die kleiner oder gleich einem vorgegebenen niedrigen Schwellenwert ist, und
den Leistungsumsetzungsabschnitt (250) zu steuern, den Ansteuerstrom (255) auf dem vorgegebenen mittleren Pegel bereitzustellen als Reaktion auf das Dimm-Steuersignal (235), das eine Spannung zeigt, die zwischen dem niedrigen und dem hohen Schwellenwert liegt.

8. Vorrichtung nach einem der Ansprüche 1 bis 7, wobei der zweite Schalter (S1) als ein Bipolartransistor (BJT) vorgesehen ist und wobei
das PWM-Signal (215) an die Basis des BJT gekoppelt ist,
der Emitter des BJT an ein Massepotenzial gekoppelt ist,
der Kollektor des BJT an einen Ausgangsknoten (232) zum Bereitstellen des Dimm-Steuersignals (235) gekoppelt ist,
ein erster Anschlusspunkt des Kondensators (C1) an den Ausgangsknoten (232) gekoppelt ist, und
ein zweiter Anschlusspunkt des Kondensators (C1) an das Massepotenzial gekoppelt ist.

9. Verwendung eines Pulsformungsabschnitts (230, 230', 230"), um ein Dimm-Steuersignal (235) für eine Vorrichtung zum Bereitstellen eines Ansteuerstroms (255) für eine oder mehrere Leuchtdioden (270) bereitzustellen, wobei die Vorrichtung Folgendes umfasst: einen Leistungsumsetzungsabschnitt (250), der eine Leistungsumsetzungseinheit im Schaltmodus zum Umsetzen der Betriebsleistung (217), die der Vorrichtung (220) zugeführt wird, in den Ansteuerstrom (255) in Übereinstimmung mit einem Ansteuersignal (245) umfasst, und einen Ansteuerabschnitt (240) zum Steuern der Bereitstellung des Ansteuerstroms (255) von dem Leistungsumsetzungsabschnitt (250) in Übereinstimmung mit der Spannung des Dimm-Steuersignals (235), wobei der Ansteuerabschnitt (240) ferner ausgelegt ist, einen ersten Schalter der Leistungsumsetzungseinheit im Schaltmodus mit einer Schaltfrequenz abwechselnd zu schließen und zu öffnen,
wobei während seiner Verwendung der Pulsformungsabschnitt (230, 230', 230") das Dimm-Steuersignal (235) auf der Grundlage eines PWM-Signals (215), das eine niedrigere Frequenz als die Schaltfrequenz aufweist, erzeugt,
wobei während seiner Verwendung ein Kondensator (C1), der in dem Pulsformungsabschnitt (230, 230', 230") enthalten ist, einen Ladestrom von Lademitteln (242, 242', 242"), die an den Kondensator (C1) sind, empfängt, wobei die Lademittel (242, 242', 242") konfiguriert sind, den Kondensator (C1) durch einen konstanten Ladestrom kontinuierlich aufzuladen,
wobei während seiner Verwendung ein zweiter Schalter (S1), der parallel zum Kondensator (C1) geschaltet ist, die Bereitstellung der Ladung von dem Kondensator (C1) als das Dimm-Steuersignal (235) in Übereinstimmung mit dem PWM-Signal (215) steuert,
und wobei während seiner Verwendung der Pulsformungsabschnitt (230, 230', 230") dabei Pulse des Dimm-Steuersignals (235) auf der Grundlage des PWM-Signals (215) ableitet, so dass die Anstiegszeit in den Pulsen des Dimm-Steuersignals (235) länger als die der Pulse des PWM-Signals (215) ist, um einen mittleren Ansteuerstrom (255) bereitzustellen, der einem kleineren Anteil eines maximalen Strompegels (Iₘₐₓ) als durch das Tastverhältnis des PWM-Signals (215) angezeigt wird, entspricht.

## Revendications

1. Appareil (220) destiné à délivrer un courant de commande (255) pour une ou plusieurs diodes électroluminescentes (270), l'appareil comprenant
une partie conversion de puissance (250) comprenant une entité de conversion de puissance en mode commuté pour convertir une puissance de fonctionnement (217) délivrée à l'appareil (220) à l'intérieur du courant de commande (255) en fonction d'un signal de commande (245),
une partie commande (240) pour générer le signal de commande (245) pour contrôler la délivrance du courant de commande (255) depuis la partie conversion de puissance (250) en fonction de la tension d'un signal de contrôle de gradation (235), la partie commande (240) étant en outre agencée pour fermer et ouvrir en alternance un premier commutateur de ladite entité de conversion de puissance en mode commuté à une fréquence de commutation, et
une partie mise en forme d'impulsion (230, 230', 230") pour générer le signal de contrôle de gradation (235) sur la base d'un signal PWM (215) qui a une fréquence inférieure à ladite fréquence de commutation,
**caractérisé en ce que** la partie mise en forme d'impulsion (230, 230', 230") comprend
- un condensateur (C1) configuré pour recevoir un courant de charge, et
- un deuxième commutateur (S1) branché en parallèle au condensateur (C1), le deuxième commutateur (S1) étant agencé pour contrôler la délivrance de la charge depuis le condensateur (C1) en tant que signal de contrôle de gradation (235) en fonction du signal PWM (215),
l'appareil comprend un moyen de charge (242, 242', 242") couplé au condensateur (C1), le moyen de charge étant configuré pour charger en continu le condensateur (C1) par un courant de charge constant,
la partie mise en forme d'impulsion (230, 230', 230") étant ainsi agencée pour dériver des impulsions du signal de contrôle de gradation (235) sur la base du signal PWM (215) de telle sorte qu'un temps de montée dans les impulsions du signal de contrôle de gradation (235) est plus long que celui des impulsions du signal PWM (215) pour délivrer un courant de commande moyen (255) qui est une plus petite partie d'un niveau de courant maximal (Iₘₐₓ) que celui indiqué par le facteur d'utilisation du signal PWM (215).

2. Appareil selon la revendication 1, dans lequel la partie commande (240) comprend une source de courant (242) configurée pour fonctionner comme le moyen de charge.

3. Appareil selon la revendication 1, dans lequel la partie mise en forme d'impulsion (230') comprend un agencement de charge (242') comprenant une source de tension (V1) couplée au condensateur (C1) par le biais d'une résistance (R1), ledit agencement de charge (242') étant configuré pour fonctionner comme le moyen de charge.

4. Appareil selon la revendication 1, dans lequel la partie mise en forme d'impulsion (230") comprend un agencement de charge (242") comprenant un miroir de courant couplé à une source de tension (V2), ledit agencement de charge (242") étant configuré pour fonctionner comme le moyen de charge.

5. Appareil selon l'une quelconque des revendications 1 à 4, dans lequel la partie commande (240) est configurée pour contrôler la partie conversion de puissance (250) pour délivrer le courant de commande (255) à un niveau intermédiaire qui est dans la gamme entre un niveau minimal prédéterminé et un niveau maximal prédéterminé, et lequel niveau intermédiaire est proportionnel ou inversement proportionnel à la tension du signal de contrôle de gradation (235).

6. Appareil selon la revendication 5, dans lequel la partie commande (240) est également configurée pour
contrôler la partie conversion de puissance (250) pour désactiver la délivrance du courant de commande (255) en réponse au signal de contrôle de gradation (235) présentant une tension qui est inférieure ou égale à un seuil bas prédéterminé,
contrôler la partie conversion de puissance (250) pour délivrer le courant de commande (255) audit niveau maximal prédéterminé en réponse au signal de contrôle de gradation (235) présentant une tension qui est supérieure ou égale à un seuil haut prédéterminé, et
contrôler la partie conversion de puissance (250) pour délivrer le courant de commande (255) au niveau intermédiaire en réponse au signal de contrôle de gradation (235) présentant une tension qui est entre les seuils bas et haut.

7. Appareil selon la revendication 5, dans lequel la partie commande (240) est également configurée pour
contrôler la partie conversion de puissance (250) pour désactiver la délivrance du courant de commande (255) en réponse au signal de contrôle de gradation (235) présentant une tension qui est supérieure ou égale à un seuil haut prédéterminé,
contrôler la partie conversion de puissance (250) pour délivrer le courant de commande (255) audit niveau maximal prédéterminé en réponse au signal de contrôle de gradation (235) présentant une tension qui est inférieure ou égale à un seuil bas prédéterminé, et
contrôler la partie conversion de puissance (250) pour délivrer le courant de commande (255) au niveau intermédiaire en réponse au signal de contrôle de gradation (235) présentant une tension qui est entre les seuils bas et haut.

8. Appareil selon l'une quelconque des revendications 1 à 7, dans lequel ledit deuxième commutateur (S1) est fourni sous la forme d'un transistor à jonction bipolaire, BJT, et dans lequel
le signal PWM (215) est couplé à la base du BJT,
l'émetteur du BJT est couplé à un potentiel de terre,
le collecteur du BJT est couplé à un noeud de sortie (232) pour délivrer le signal de contrôle de gradation (235),
une première borne du condensateur (C1) est couplée audit noeud de sortie (232), et
une deuxième borne du condensateur (C1) est couplée au potentiel de terre.

9. Utilisation d'une partie mise en forme d'impulsion (230, 230', 230") pour délivrer un signal de contrôle de gradation (235) pour un appareil destiné à délivrer un courant de commande (255) pour une ou plusieurs diodes électroluminescentes (270), l'appareil comprenant une partie conversion de puissance (250) comprenant une entité de conversion de puissance en mode commuté pour convertir une puissance de fonctionnement (217) délivrée à l'appareil à l'intérieur du courant de commande (255) en fonction d'un signal de commande (245), et une partie commande (240) pour contrôler la délivrance du courant de commande (255) depuis la partie conversion de puissance (250) en fonction de la tension d'un signal de contrôle de gradation (235), la partie commande (240) étant agencée en outre pour fermer et ouvrir en alternance un premier commutateur de ladite entité de conversion de puissance en mode commuté à une fréquence de commutation,
utilisation pendant laquelle la partie mise en forme d'impulsion (230, 230', 230") génère le signal de contrôle de gradation (235) sur la base d'un signal PWM (215) qui a une fréquence inférieure à ladite fréquence de commutation,
et utilisation pendant laquelle un condensateur (C1) compris dans la partie mise en forme d'impulsion (230, 230', 230") reçoit un courant de charge provenant d'un moyen de charge (242, 242', 242") couplé au condensateur (C1), lequel moyen de charge (242, 242', 242") est configuré pour charger en continu le condensateur (C1) par un courant de charge constant,
et utilisation pendant laquelle un deuxième commutateur (S1) branché en parallèle au condensateur (C1) contrôle la délivrance de la charge depuis le condensateur (C1) en tant que signal de contrôle de gradation (235) en fonction du signal PWM (215),
et utilisation pendant laquelle la partie mise en forme d'impulsion (230, 230', 230") dérive ainsi des impulsions du signal de contrôle de gradation (235) sur la base du signal PWM (215) de telle sorte qu'un temps de montée dans les impulsions du signal de contrôle de gradation (235) est plus long que celui des impulsions du signal PWM (215) pour délivrer un courant de commande moyen (255) qui est une plus petite partie d'un niveau de courant maximal (Iₘₐₓ) que celui indiqué par le facteur d'utilisation du signal PWM (215).
